# EUROPEAN PATENT SPECIFICATION

(11) **EP 4 716 097 B1**
(45) Date of publication and mention of the grant of the patent: **04.11.2026**
(21) Application number: 25152456.7
(22) Date of filing: 17.01.2025
(51) Int. Cl.: H03F 1/02, H03F 3/195, H03F 3/45, H03G 3/00, H03F 1/56

(54) **VARIABLE GAIN AMPLIFIER AND OPERATION METHOD THEREOF**
VERSTÄRKER MIT VARIABLER VERSTÄRKUNG UND BETRIEBSVERFAHREN DAFÜR
AMPLIFICATEUR À GAIN VARIABLE ET SON PROCÉDÉ DE FONCTIONNEMENT

(30) Priority: 24.09.2024 US 202418893981
(43) Date of publication of application: 25.03.2026
(73) Proprietor: Industrial Technology Research Institute, 310401 Hsinchu (TW)
(72) Inventor: Tsai, Jeng-Han, 106032 Taipei City (TW); Chang, Ying-Chen, 320677 Taoyuan City (TW); Wu, Ping-Hsun, 334021 Taoyuan City (TW)
(74) Representative: Kurig, Thomas

(56) References cited:
- DING KAIJIE ET AL: "A 23-GHz TX/LNA Front-End Module for Inter-Satellite Links With 27.8% Peak Efficiency in the TX Path and 3.1-dB NF in the RX Path", IEEE JOURNAL OF SOLID-STATE CIRCUITS, IEEE, USA, vol. 59, no. 11, 24 May 2024 (2024-05-24), pages 3644 - 3654, XP011987588, ISSN: 0018-9200, [retrieved on 20240524], DOI: 10.1109/JSSC.2024.3396372
- ZHANG JIAJUN ET AL: "A 20-GHz 1.9-mW LNA Using gm-Boost and Current-Reuse Techniques in 65-nm CMOS for Satellite Communications", IEEE JOURNAL OF SOLID-STATE CIRCUITS, IEEE, USA, vol. 55, no. 10, 1 June 2020 (2020-06-01), pages 2714 - 2723, XP011811038, ISSN: 0018-9200, [retrieved on 20200923], DOI: 10.1109/JSSC.2020.2995307
- IHM G-J ET AL: "CMOS Low-Noise Amplifier Design Optimization Techniques", IEEE TRANSACTIONS ON MICROWAVE THEORY AND TECHNIQUES, IEEE, USA, vol. 52, no. 5, 1 May 2004 (2004-05-01), pages 1433 - 1442, XP011112271, ISSN: 0018-9480, DOI: 10.1109/TMTT.2004.827014
- REDDY K VASUDEVA ET AL: "A 280[mu]W sub-threshold Balun LNA for medical radio using current re-use technique", 2017 1ST CONFERENCE ON PHD RESEARCH IN MICROELECTRONICS AND ELECTRONICS LATIN AMERICA (PRIME-LA), IEEE, 20 February 2017 (2017-02-20), pages 1 - 4, XP033090639, DOI: 10.1109/PRIME-LA.2017.7899171
- FU XI ET AL: "A Low-Power 256-Element Ka -Band CMOS Phased-Array Receiver With On-Chip Distributed Radiation Sensors for Small Satellite Constellations", IEEE JOURNAL OF SOLID-STATE CIRCUITS, vol. 58, no. 12, 1 December 2023 (2023-12-01), USA, pages 3380 - 3395, XP093287617, ISSN: 0018-9200, DOI: 10.1109/JSSC.2023.3312535

## Description

### BACKGROUND

### Technical Field

The disclosure relates to a variable gain amplifier, and particularly relates to a variable gain amplifier and an operation method thereof.

### Related Art

With the advancement of wireless communication technology, phased array antennas have become widely used in fifth-generation (5G) mobile communication systems. Typically, the variable gain amplifier in the phased array antenna has to offer a sufficiently wide adjustable gain range, low noise figure, and low phase variation characteristics under different gains. In order to achieve the function of adjustable gain, conventional variable gain amplifiers usually adopt an amplifier architecture of the cascode configuration. However, the amplifier architecture of the cascode configuration tends to have a higher noise figure compared to the amplifier in the common source stage configuration. Therefore, conventional phased array antenna systems usually require the addition of a low-noise amplifier before the variable gain amplifier to reduce the noise figure of the radio frequency receiving link.

In addition, conventional variable gain amplifiers are usually affected by parasitic capacitance effects, which causes the phases of multiple radio frequency links to change when the gain is adjusted. As a result, providing a variable gain amplifier with both low noise figure and low phase variation characteristics is a critical need for improvement in the field of wireless communications.

NPL document title "A 23-GHz TX/LNA Front-End Module for Inter-Satellite Links With 27.8% Peak Efficiency in the TX Path and 3.1-dB NF in the RX Path" by Kaijie Ding et al discloses a LNA with a transformer connecting two stages wherein the dc current between the two stages is shared.

### SUMMARY

The disclosure provides a variable gain amplifier and an operation method thereof, which can adjust the gain of the amplifier through an analog interface or a digital interface, and has low noise figure and low phase variation characteristics.

An embodiment of the disclosure provides a variable gain amplifier. The variable gain amplifier includes a first stage common-source (CS) amplifier, a second stage CS amplifier, and a first transformer. The second stage CS amplifier includes a differential circuit and a current steering circuit. The differential circuit and the current steering circuit are coupled to a common connecting node, and the current steering circuit draws at least part of a current flowing through the differential circuit from the common connecting node. The first transformer has a primary side and a secondary side. The first terminal of the primary side is coupled to the output terminal of the first stage CS amplifier, and the second terminal of the primary side is coupled to the common connecting node. The first terminal of the secondary side is coupled to the first differential input terminal of the differential circuit, and the second terminal of the secondary side is coupled to the second differential input terminal of the differential circuit.

Another embodiment of the disclosure provides an operation method of a variable gain amplifier. The variable gain amplifier includes a first stage CS amplifier, a second stage CS amplifier, and a first transformer. The first transformer is coupled between the first stage CS amplifier and the second stage CS amplifier. The operation method includes: configuring a differential circuit and a current steering circuit in the second stage CS amplifier, in which the differential circuit and the current steering circuit are coupled to a common connecting node, and the common connecting node is a virtual ground node; drawing at least part of a current flowing through the differential circuit from the common connecting node using the current steering circuit; and changing a gain of the variable gain amplifier according to a current amount drawn by the current steering circuit.

Based on the above, in various embodiments of the disclosure, the variable gain amplifier adopts a two-stage common source amplifier circuit architecture, so the variable gain amplifier of the disclosure has a lower noise figure compared to the variable gain amplifier structure of the cascode configuration. In addition, the second stage CS amplifier of the disclosure is configured with the differential circuit and the current steering circuit, and the differential circuit and the current steering circuit are jointly coupled to the virtual ground node. In this way, the current steering circuit of the disclosure can draw at least part of the current flowing through the differential circuit from the virtual ground node, and change the gain of the variable gain amplifier according to the current amount drawn by the current steering circuit. Furthermore, the disclosure can also eliminate the parasitic capacitance effect generated by the transistor in the second stage CS amplifier by adding a capacitor (or a neutralizing capacitor) between differential pair transistors in the second stage CS amplifier. Therefore, the variable gain amplifier of the disclosure can achieve low phase variations under different gains.

In order to make the above-mentioned features and advantages of the disclosure more comprehensible, embodiments are given below and described in detail with reference to the accompanying drawings.

### BRIEF DESCRIPTION OF THE DRAWINGS

FIG. 1 is a block diagram of a variable gain amplifier according to an embodiment of the disclosure.
FIG. 2 is a flow chart of an operation method of a variable gain amplifier according to an embodiment of the disclosure.
FIG. 3A is a schematic circuit diagram illustrating the variable gain amplifier in FIG. 1 according to an embodiment of the disclosure.
FIG. 3B is a schematic circuit diagram illustrating the variable gain amplifier in FIG. 1 according to another embodiment of the disclosure.
FIG. 4 illustrates a measurement result and a simulation result of a noise figure of the variable gain amplifier in FIG. 3A according to an embodiment of the disclosure.
FIG. 5A illustrates measurement results and simulation results of S-parameters of the variable gain amplifier in FIG. 3A according to an embodiment of the disclosure.
FIG. 5B illustrates measurement results and simulation results of the S-parameters of the variable gain amplifier in FIG. 3B under different gains according to an embodiment of the disclosure.
FIG. 6 illustrates measurement results and simulation results of a gain control range of the variable gain amplifier in FIG. 3A according to an embodiment of the disclosure.
FIG. 7 illustrates gains and phase variations of the variable gain amplifier in FIG. 3B in different digital states according to an embodiment of the disclosure.

### DESCRIPTION OF THE EMBODIMENTS

The word "coupled (or connected)" used throughout the specification of the application (including the appended claims) can refer to any direct or indirect means of connection. For example, if a first device is described as being coupled (or connected) to a second device, then it should be interpreted to mean that the first device may be directly connected to the second device, or that the first device may be indirectly connected to the second device through other devices or some means of connection. The terms "first," "second," and similar designations mentioned throughout the specification of the application (including the appended claims) are used to name elements or to distinguish different embodiments or scopes; the terms are not intended to limit the upper limit or lower limit of the number of elements and are not to limit the order of elements. Additionally, wherever possible, elements/components/steps using the same reference numerals are used in the drawings and embodiments to represent the same or similar parts. Elements/components/steps using the same numerals or the same terms in different embodiments can refer to the relevant descriptions of each other.

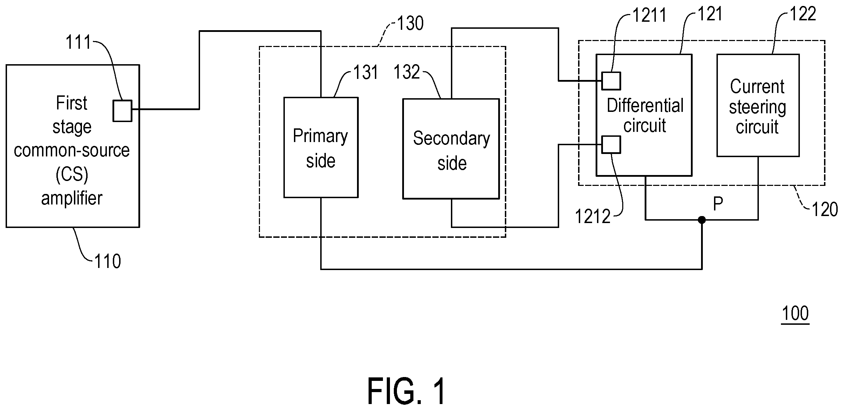

FIG. 1 is a block diagram of a variable gain amplifier according to an embodiment of the disclosure. Referring to FIG. 1, a variable gain amplifier 100 includes a first stage common-source (CS) amplifier 110, a second stage CS amplifier 120, and a transformer 130. The second stage CS amplifier 120 includes a differential circuit 121 and a current steering circuit 122. The differential circuit 121 and the current steering circuit 122 are coupled to a common connecting node P, and the current steering circuit 122 may draw at least part of a current flowing through the differential circuit 121 from the common connecting node P. The transformer 130 has a primary side 131 and a secondary side 132. The first terminal of the primary side 131 of the transformer 130 is coupled to an output terminal 111 of the first stage CS amplifier 110, and the second terminal of the primary side 131 of the transformer 130 is coupled to the common connecting node P. The first terminal of the secondary side 132 of the transformer 130 is coupled to a first differential input terminal 1211 of the differential circuit 121, and the second terminal of the secondary side 132 of the transformer 130 is coupled to a second differential input terminal 1212 of the differential circuit 121.

In the embodiment of FIG. 1, in order for the second stage CS amplifier 120 to have a current steering mechanism, the disclosure adds a single-ended to differential transformer 130 between the first stage CS amplifier 110 and the second stage CS amplifier 120, and the second stage CS amplifier 120 operates in a differential mode. Thus, the common connecting node P of both the differential circuit 121 and the current steering circuit 122 may become a virtual ground node. As a result, the current flowing through the differential circuit 121 and the current flowing through the current steering circuit 122 can be collected into the common connecting node P, and the collected current may flow through the first stage CS amplifier 110 through the primary side 131 of the transformer 130. Consequently, the current steering function could be realized in the architecture of the two-stage common source amplifier circuit.

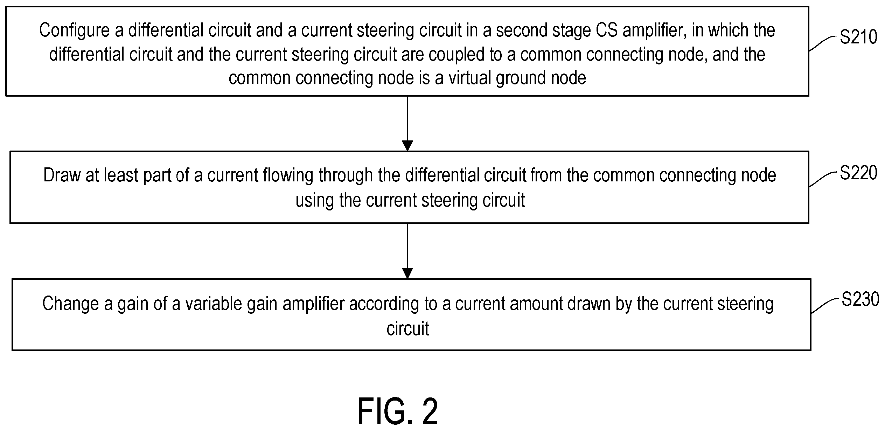

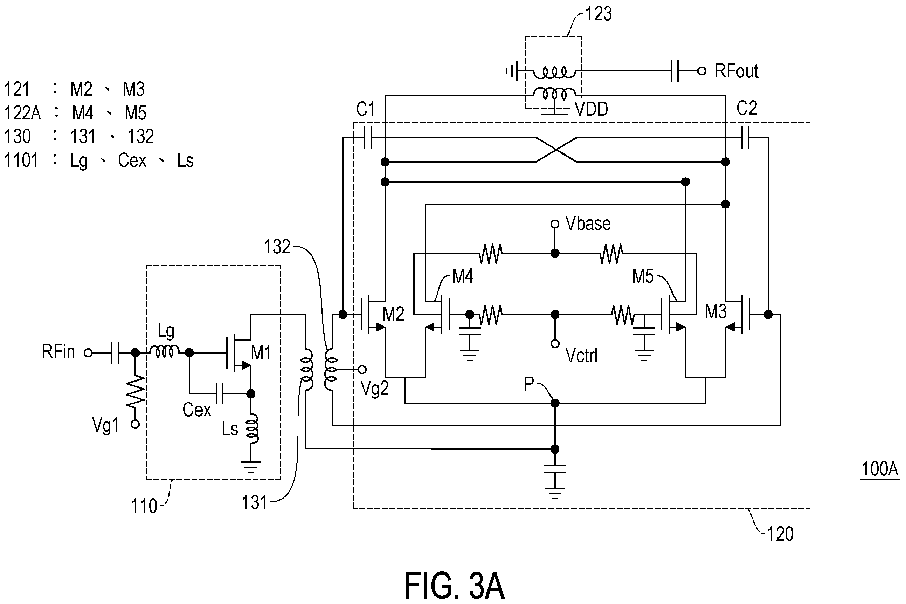

FIG. 2 is a flow chart of an operation method of a variable gain amplifier according to an embodiment of the disclosure. FIG. 3A is a schematic circuit diagram illustrating the variable gain amplifier in FIG. 1 according to an embodiment of the disclosure. Referring to FIG. 2 and FIG. 3A, in Step S210, a differential circuit 121 and a current steering circuit 122A may be configured in the second stage CS amplifier 120 of the variable gain amplifier 100A. For example, the differential circuit 121 in FIG. 3A may include a transistor M2 and a transistor M3. The first terminal of the transistor M2 is coupled to the common connecting node P. The control terminal of the transistor M2 may serve as the first differential input terminal of the differential circuit 121 (that is, 1211 in FIG. 1), and the second terminal of the transistor M2 may serve as the first output terminal of the differential circuit 121. The first terminal of the transistor M3 is coupled to the common connecting node P. The control terminal of the transistor M3 may serve as the second differential input terminal of the differential circuit 121 (that is, 1212 in FIG. 1), and the second terminal of the transistor M3 may be used as the second output terminal of the differential circuit 121. In addition, by adding the single-ended to differential transformer 130 between the first stage CS amplifier 110 and the second stage CS amplifier 120, the common connecting node P may be made into the virtual ground node.

Referring to FIG. 3A again, the current steering circuit 122A may include a transistor M4 and a transistor M5. The first terminal of the transistor M4 is coupled to the common connecting node P, the control terminal of the transistor M4 is coupled to a control voltage Vctrl, and the second terminal of the transistor M4 is coupled to the second terminal of the transistor M3. The first terminal of the transistor M5 is coupled to the common connecting node P, the control terminal of the transistor M5 is coupled to the control voltage Vctrl, and the second terminal of the transistor M5 is coupled to the second terminal of the transistor M2. In the embodiment of FIG. 3A, the transistors M2 to M5 are presented as N-type field effect transistors for illustrative purposes only and are not intended to limit the disclosure. In other embodiments, the transistors M2 to M5 may also be P-type transistors. In addition, the transistors M2 to M5 may also be bipolar transistors or heterobipolar junction transistors, but are not limited thereto.

Referring to FIG. 2 and FIG. 3A, in Step S220, the current steering circuit 122A may draw at least part of the current flowing through the differential circuit 121 from the common connecting node P. FIG. 3A shows the use of an analog control interface to adjust the gain of the variable gain amplifier 100A. For example, the current steering circuit 122A may receive the control voltage Vctrl, and adjust the amount of the current drawn by the current steering circuit 122A according to the amount of the control voltage Vctrl, thereby changing the amount of the current flowing through the differential circuit 121. In Step S230, the disclosure can change the gain of the variable gain amplifier 100A according to the current amount drawn by the current steering circuit 122A.

In detail, when the transistor M4 and the transistor M5 are not turned on by the control voltage Vctrl, the DC current output by the transistor M1 flows through the transistor M2 and the transistor M3. At this time, the variable gain amplifier 100A has the maximum gain. When the control voltage Vctrl increases to a voltage value that can turn on the transistor M4 and the transistor M5, part of the DC current output by the transistor M1 flows through the transistor M4 and the transistor M5, causing the current flowing through the transistor M2 and the transistor M3 to decrease, and at this time, the gain of the variable gain amplifier 100A is reduced. Therefore, the disclosure could adjust the magnitude of the gain of the variable gain amplifier 100A by controlling how much current is drawn from main current paths (the transistor M2 and the transistor M3) by auxiliary current paths (the transistor M4 and the transistor M5).

In the embodiment of FIG. 3A, the first stage CS amplifier 110 includes a transistor M1 and an input matching network 1101.. The input matching network 1101 includes an inductor Lg, a matching capacitor Cex, and an inductor Ls. The input terminal of the first stage CS amplifier 110 may receive a radio frequency input signal RFin and a bias voltage Vg1. The inductor Lg is coupled between the input terminal of the first stage CS amplifier and the control terminal of the transistor M1. The matching capacitor Cex is coupled between the control terminal of the transistor M1 and the first terminal of the transistor M1. The inductor Ls is coupled between the second terminal of the transistor M1 and a ground terminal. The input matching network 1101 may be used to implement noise matching and input conjugate matching. The second terminal of the transistor M1 may serve as the output terminal of the first stage CS amplifier 110 (that is, 111 in FIG. 1).

In the embodiment of FIG. 3A, the transistor M1 is presented as an N-type field effect transistor for illustrative purposes only and is not intended to limit the disclosure. In other embodiments, the transistor M1 may also be a P-type transistor. In addition, the transistor M1 may also be a bipolar transistor or a heterobipolar junction transistor. According to the design requirements, the inter-stage matching network between the first stage CS amplifier 110 and the second stage CS amplifier 120, inter-stage matching may also be achieved through the inductance values of the primary side 131 and the secondary side 132 of the transformer 130, the turns ratio between the primary side 131 and the secondary side 132, or the coupling amount between the primary side 131 and the secondary side 132. In addition, the center tap end of the secondary side 132 of the transformer 130 may provide a bias voltage Vg2 to the control terminals of the transistor M2 and the transistor M3, and the center tap end of the primary side of the transformer 123 may provide an operating voltage VDD to the transistor M2 and the transistor M3. The output of the second stage CS amplifier 120 may convert the differential output into a single-ended output through the transformer 123, allowing the radio frequency output signal RFout to be provided to the next stage circuit (not shown).

Generally speaking, the phase variation of the variable gain amplifier under different gain states is positively related to the parasitic capacitance value of the transistor in the variable gain amplifier. Therefore, in the embodiment of FIG. 3A, the disclosure may eliminate the parasitic capacitance values of the multiple transistors (that is, M2, M3, M4, and M5) in the second stage CS amplifier 120 by adding capacitors at specific positions in the second stage CS amplifier 120, in order to enable the variable gain amplifier 100A to achieve low phase variations at different gains. As shown in FIG. 3A, the second stage CS amplifier 120 further includes a capacitor C1 and a capacitor C2. The first terminal of the capacitor C1 is coupled to the control terminal of the transistor M2, and the second terminal of the capacitor C1 is coupled to the second terminal of the transistor M3 and the second terminal of the transistor M4. The first terminal of the capacitor C2 is coupled to the control terminal of the transistor M3, and the second terminal of the capacitor C2 is coupled to the second terminal of the transistor M2 and the second terminal of the transistor M5. Since the capacitor C1 and the capacitor C2 could eliminate the parasitic capacitance values of the multiple transistors (that is, M2, M3, M4, and M5) in the second stage CS amplifier 120, the variable gain amplifier 100A achieves low phase variations at different gains, so the capacitor C1 and the capacitor C2 may also be called neutralizing capacitors.

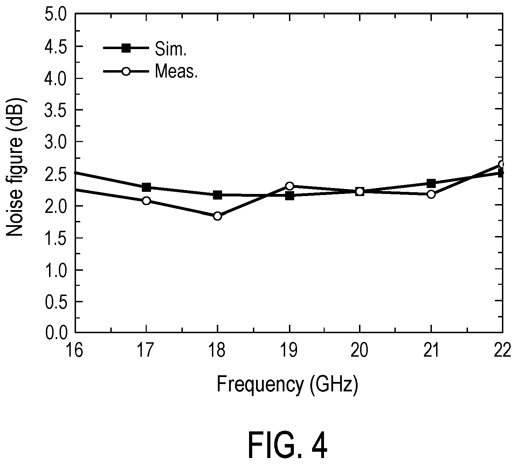

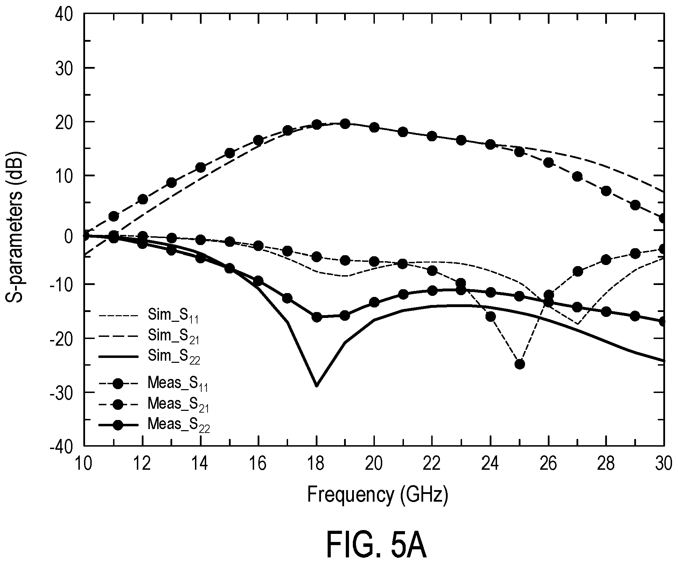

FIG. 4 illustrates a measurement result and a simulation result of a noise figure of the variable gain amplifier in FIG. 3A according to an embodiment of the disclosure. As shown in FIG. 4, the variable gain amplifier 100A in FIG. 3A may maintain a noise figure of less than 2.5dB in the frequency range of 17 to 21 GHz. Therefore, the variable gain amplifier 100A of the disclosure could be used to replace the conventional receiver architecture of a phased array transceiver that requires a variable gain amplifier and another low noise amplifier. FIG. 5A illustrates measurement results and simulation results of S-parameters of the variable gain amplifier in FIG. 3A according to an embodiment of the disclosure. It may be seen from the S21 parameter in FIG. 5A that the variable gain amplifier 100A in FIG. 3A could achieve a gain of more than 15dB in the frequency range of 18 to 25 GHz.

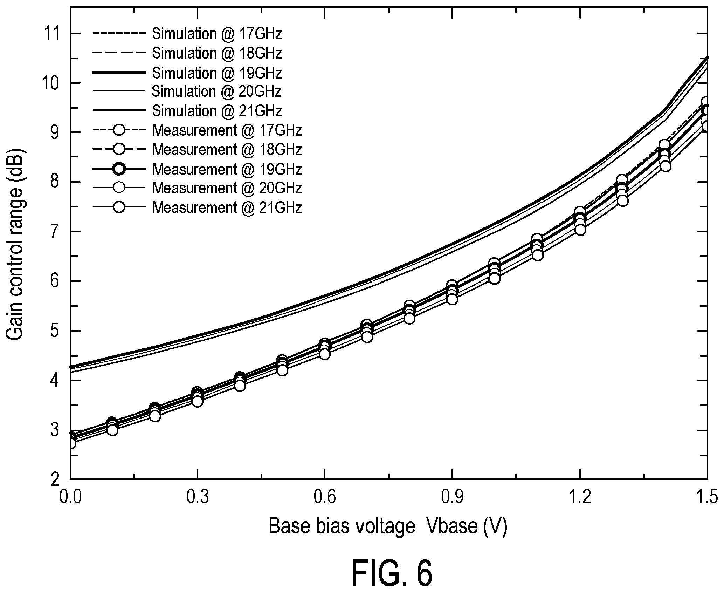

In the embodiment of FIG. 3A, the disclosure may also apply a base bias voltage Vbase to the second stage CS amplifier 120 in the variable gain amplifier 100A, which enables the variable gain amplifier 100A to provide sufficient gain control range when operating at low voltage (for example: VDD is less than or equal to 1 volt). For example, the current steering circuit 122A may apply the base bias voltage Vbase to body terminals of both the transistor M4 and the transistor M5 to increase the current amounts drawn by both the transistor M4 and the transistor M5. In this way, the variable gain amplifier 100A could provide sufficient gain control range even under low voltage operation (for example: VDD is less than or equal to 1 volt). In addition, it should be noted that the body terminals of the transistor M4 and the transistor M5 are different from the first terminals (source terminals) of both the transistor M4 and the transistor M5, and are also different from the second terminals (drain terminals) of both the transistor M4 and the transistor M5. FIG. 6 illustrates measurement results and simulation results of a gain control range of the variable gain amplifier in FIG. 3A according to an embodiment of the disclosure. As shown in FIG. 6, the variable gain amplifier 100A in FIG. 3A could achieve a variable gain range of more than 9dB when the base bias voltage Vbase is 1.5V.

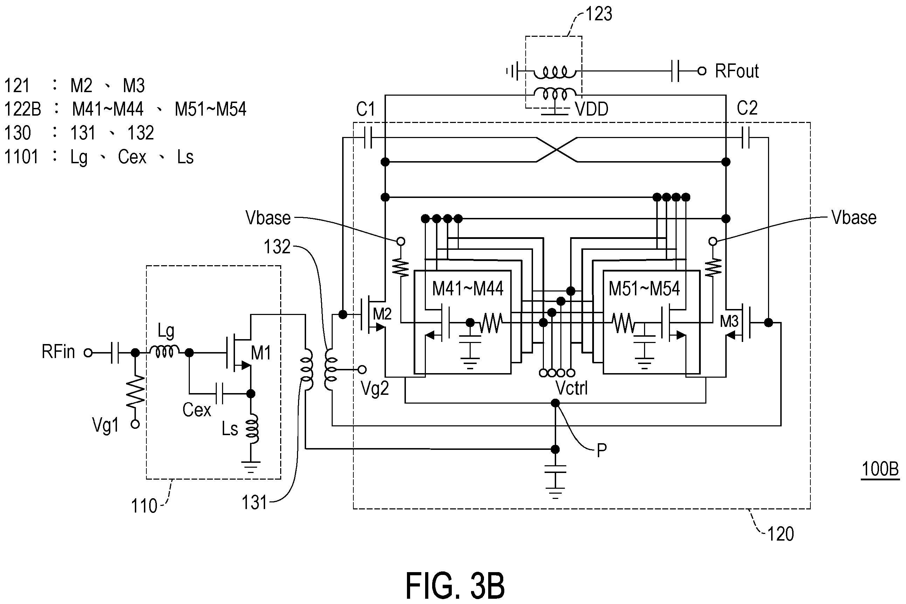

The disclosure may also use a digital control interface to adjust the gain of the variable gain amplifier. FIG. 3B is a schematic circuit diagram illustrating the variable gain amplifier in FIG. 1 according to another embodiment of the disclosure. The difference between FIG. 3B and FIG. 3A is that a current steering circuit 122B in a variable gain amplifier 100B in FIG. 3B includes a transistor group formed by a plurality of sub-transistors M41 to M44 and a transistor group formed by a plurality of sub-transistors M51 to M54. The first terminal of each sub-transistor among the plurality of sub-transistors M41 to M44 is coupled to the common connecting node P, the control terminal of each sub-transistor among the plurality of sub-transistors M41 to M44 is coupled to a digital control signal Vctrl, and the second terminal of each sub-transistor among the plurality of sub-transistors M41 to M44 is coupled to the second terminal of the transistor M3. The first terminal of each sub-transistor among the plurality of sub-transistors M51 to M54 is coupled to the common connecting node P, the control terminal of each sub-transistor among the plurality of sub-transistors M51 to M54 is coupled to the digital control signal Vctrl, and the second terminal of each sub-transistor among the plurality of sub-transistors M51 to M54 is coupled to the second terminal of the transistor M2.

In the embodiment of FIG. 3B, the current steering circuit 122B may use the digital control signal Vctrl (such as a digital code) to individually control the conduction state of each sub-transistor M41 to M44 and M51 to M54, which allows the current steering circuit 122B to draw currents of different current values from the common connecting node P, thereby adjusting the gain of the variable gain amplifier 100B. In addition, the current steering circuit 122B may further apply the base bias voltage Vbase to the body terminal of each sub-transistor M41 to M44 and M51 to M54 to increase the current amounts drawn by the sub-transistors M41 to M44 and M51 to M54. In this way, the variable gain amplifier 100B could provide a sufficient gain control range even under low voltage operation (for example: VDD is less than or equal to 1 volt). In addition, it should be noted that the body terminal of each sub-transistor M41 to M44 and M51 to M54 is different from the first terminal (source terminal) of each sub-transistor M41 to M44 and M51 to M54, and is also different from the second terminal (drain terminal) of each sub-transistor M41 to M44 and M51 to M54.

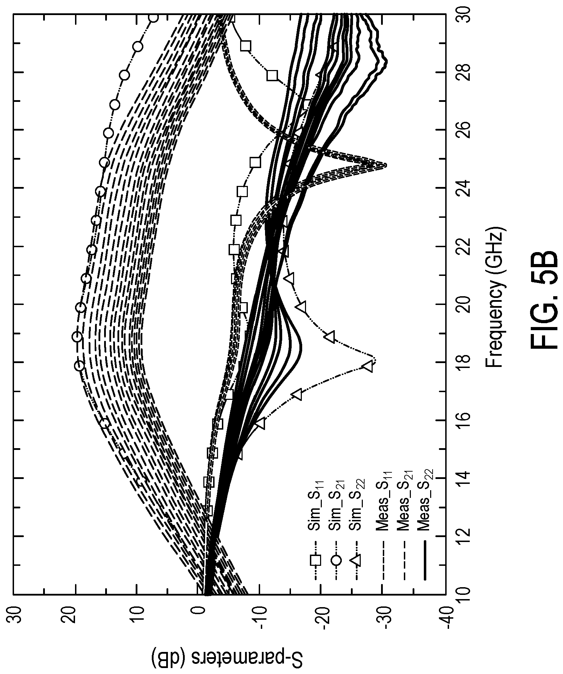

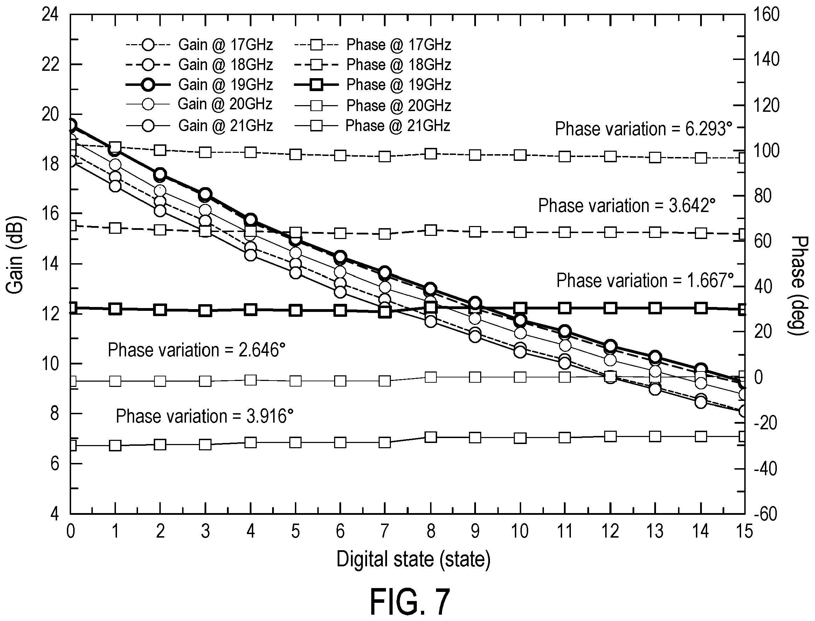

In addition, since the gain of the variable gain amplifier 100B could be adjusted through the digital control signal Vctrl in FIG. 3B, the complexity of the system control can be further reduced. FIG. 5B illustrates measurement results and simulation results of the S-parameters of the variable gain amplifier in FIG. 3B under different gains according to an embodiment of the disclosure. As shown in the S21 parameter in FIG. 5B, under the control of the digital control signal Vctrl, the variable gain amplifier 100B in FIG. 3B could achieve a gain of more than 15dB in the frequency range of 18 to 25 GHz. FIG. 7 illustrates gains and phase variations of the variable gain amplifier in FIG. 3B in different digital states according to an embodiment of the disclosure. As shown in FIG. 7, the variable gain amplifier 100B in FIG. 3B could achieve a gain of more than 8dB and maintain low phase variation characteristics in sixteen digital states. Therefore, the variable gain amplifier in FIG. 3B is suitable for application as a beamformer in a phased array antenna system.

In summary, in the embodiments of the disclosure, the variable gain amplifier adopts the two-stage common source amplifier circuit architecture, so the variable gain amplifier of the disclosure has a lower noise figure compared to the variable gain amplifier structure of the cascode configuration. In addition, the second stage CS amplifier of the disclosure is configured with the differential circuit and the current steering circuit, and the differential circuit and the current steering circuit are jointly coupled to the virtual ground node. In this way, the current steering circuit of the disclosure can draw at least part of the current flowing through the differential circuit from the virtual ground node, and change the gain of the variable gain amplifier according to the current amount drawn by the current steering circuit. Furthermore, the disclosure could also eliminate the parasitic capacitance effect generated by the transistor in the second stage CS amplifier by adding the capacitor (or the neutralizing capacitor) between the differential pair transistors in the second stage CS amplifier. Therefore, the variable gain amplifier of the disclosure can achieve low phase variations under different gains.

Although the disclosure has been disclosed above through embodiments, the embodiments are not intended to limit the disclosure. Persons with ordinary knowledge in the relevant technical field may make some changes and modifications without departing from the scope of the claims Therefore, the protection scope of the disclosure shall be determined by the appended claims.

## Claims

1. A variable gain amplifier (100), comprising:
a first stage common-source (CS) amplifier (110);
a second stage CS amplifier (120) comprising a differential circuit (121) and a current steering circuit (122), wherein the differential circuit (121) and the current steering circuit (122) are coupled to a common connecting node (P), and the current steering circuit (122) draws at least part of a current flowing through the differential circuit (121) from the common connecting node (P); and
a first transformer (130) comprising a primary side (131) and a secondary side (132), wherein a first terminal of the primary side (131) is coupled to an output terminal of the first stage CS amplifier (110), a second terminal of the primary side (131) is coupled to the common connecting node (P), a first terminal of the secondary side (132) is coupled to a first differential input terminal of the differential circuit (121), and a second terminal of the secondary side (132) is coupled to a second differential input terminal of the differential circuit (121).

2. The variable gain amplifier (100) as claimed in claim 1, wherein the common connecting node (P) is a virtual ground node.

3. The variable gain amplifier (100) as claimed in claim 1, wherein the first stage CS amplifier (110) comprises:
a first transistor (M1), wherein a second terminal of the first transistor (M1) serves as the output terminal of the first stage CS amplifier (110); and
an input matching network (1101) comprising a first inductor (Lg), a matching capacitor (Cex), and a second inductor (Ls), wherein the first inductor (Lg) is coupled between an input terminal of the first stage CS amplifier (110) and a control terminal of the first transistor (M1), the matching capacitor (Cex) is coupled between the control terminal of the first transistor (M1) and a first terminal of the first transistor (M1), and the second inductor (Ls) is coupled between the first terminal of the first transistor (M1) and a ground terminal.

4. The variable gain amplifier (100) as claimed in claim 1, wherein the differential circuit (121) comprises:
a second transistor (M2), wherein a first terminal of the second transistor (M2) is coupled to the common connecting node (P), a control terminal of the second transistor (M2) serves as the first differential input terminal of the differential circuit (121), and a second terminal of the second transistor (M2) serves as a first output terminal of the differential circuit (121); and
a third transistor (M3), wherein a first terminal of the third transistor (M3) is coupled to the common connecting node (P), a control terminal of the third transistor (M3) serves as the second differential input terminal of the differential circuit (121), and a second terminal of the third transistor (M3) serves as a second output terminal of the differential circuit (121).

5. The variable gain amplifier (100) as claimed in claim 4, wherein the current steering circuit (122) comprises:
a fourth transistor (M4), wherein a first terminal of the fourth transistor (M4) is coupled to the common connecting node (P), a control terminal of the fourth transistor (M4) is coupled to a control voltage (Vctrl), and a second terminal of the fourth transistor (M4) is coupled to a second terminal of the third transistor (M3); and
a fifth transistor (M5), wherein a first terminal of the fifth transistor (M5) is coupled to the common connecting node (P), a control terminal of the fifth transistor (M5) is coupled to the control voltage (Vctrl), and a second terminal of the fifth transistor (M5) is coupled to a second terminal of the second transistor (M2).

6. The variable gain amplifier (100) as claimed in claim 4, wherein the current steering circuit (122) comprises:
a fourth transistor group comprising a plurality of fourth sub-transistors (M41 to M44), wherein a first terminal of each of the fourth sub-transistors (M41 to M44) is coupled to the common connecting node (P), a control terminal of each of the fourth sub-transistors (M41 to M44) is coupled to a digital control signal, and a second terminal of each of the fourth sub-transistors (M41 to M44) is coupled to a second terminal of the third transistor (M3); and
a fifth transistor group comprising a plurality of fifth sub-transistors (M51 to M54), wherein a first terminal of each of the fifth sub-transistors (M51 to M54) is coupled to the common connecting node (P), a control terminal of each of the fifth sub-transistors (M51 to M54) is coupled to the digital control signal, and a second terminal of each of the fifth sub-transistors (M51 to M54) is coupled to a second terminal of the second transistor (M2).

7. The variable gain amplifier (100) as claimed in claim 5, wherein the second stage CS amplifier (120) further comprises:
a first capacitor (C1), wherein a first terminal of the first capacitor (C1) is coupled to the control terminal of the second transistor (M2), a second terminal of the first capacitor (C1) is coupled to the second terminal of the third transistor (M3) and the second terminal of the fourth transistor (M4); and
a second capacitor (C2), wherein a first terminal of the second capacitor (C2) is coupled to the control terminal of the third transistor (M3), and a second terminal of the second capacitor (C2) is coupled to the second terminal of the second transistor (M2) and the second terminal of the fifth transistor (M5).

8. The variable gain amplifier (100) as claimed in claim 1, further comprising:
a second transformer (123) coupled to a first output terminal of the differential circuit (121) and a second output terminal of the differential circuit (121).

9. An operation method of a variable gain amplifier (100), wherein the variable gain amplifier (100) comprises a first stage CS amplifier (110), a second stage CS amplifier (120), and a first transformer (130), the first transformer (130) is coupled between the first stage CS amplifier (110) and the second stage CS amplifier (120), and the operation method comprises:
configuring a differential circuit (121) and a current steering circuit (122) in the second stage CS amplifier (120), wherein the differential circuit (121) and the current steering circuit (122) are coupled to a common connecting node (P), and the common connecting node (P) is a virtual ground node;
drawing at least part of a current flowing through the differential circuit (121) from the common connecting node (P) using the current steering circuit (122); and
changing a gain of the variable gain amplifier (100) according to a current amount drawn by the current steering circuit (122).

10. The operation method as claimed in claim 9, wherein drawing at least part of the current flowing through the differential circuit (121) from the common connecting node (P) using the current steering circuit (122) comprises:
controlling a current drawn by the current steering circuit (122) using a control voltage (Vctrl); and
changing the current flowing through the differential circuit (121) according to the current drawn by the current steering circuit (122).

11. The operation method as claimed in claim 9, further comprising:
configuring a first capacitor (C1) and a second capacitor (C2) in the second stage CS amplifier (120), wherein a first terminal of the first capacitor (C1) is coupled to a first differential input terminal of the differential circuit (121), and a second terminal of the first capacitor (C1) is coupled to a second output terminal of the differential circuit (121) and a first output terminal of the current steering circuit (122), wherein a first terminal of the second capacitor (C2) is coupled to a second differential input terminal of the differential circuit (121), and a second terminal of the second capacitor (C2) is coupled to a first output terminal of the differential circuit (121) and a second output terminal of the current steering circuit (122); and
eliminating parasitic capacitance values in the differential circuit (121) and the current steering circuit (122) using the first capacitor (C1) and the second capacitor (C2).

12. The operation method as claimed in claim 9, wherein the current steering circuit (122) comprises a plurality of sub-transistors (M41 to M44 and M51 to M54), and the operation method further comprises:
controlling a conduction state of each of the sub-transistors (M41 to M44 and M51 to M54) using a digital control signal (Vctrl), so that the current steering circuit (122) draws currents of different current values from the common connecting node (P); and
changing a gain of the variable gain amplifier (100) according to the currents of the different current values drawn by the current steering circuit (122).

13. The operation method as claimed in claim 9, further comprising:
operating the second stage CS amplifier (120) at an operating voltage (VDD), wherein the operating voltage (VDD) is less than or equal to 1 volt.

## Patentansprüche

1. Ein Verstärker mit variabler Verstärkung (100), umfassend:
einen Common-Source-(CS)-Verstärker (110) der ersten Stufe;
einen CS-Verstärker (120) der zweiten Stufe, umfassend eine Differenzschaltung (121) und eine Stromlenkschaltung (122), wobei die Differenzschaltung (121) und die Stromlenkschaltung (122) mit einem gemeinsamen Verbindungsknoten (P) gekoppelt sind, und die Stromlenkschaltung (122) zumindest einen Teil eines Stroms, der durch die Differenzschaltung (121) fließt, von dem gemeinsamen Verbindungsknoten (P) abzieht; und
einen ersten Transformator (130), umfassend eine Primärseite (131) und eine Sekundärseite (132), wobei ein erster Anschluss der Primärseite (131) mit einem Ausgangsanschluss des CS-Verstärkers (110) der ersten Stufe gekoppelt ist, ein zweiter Anschluss der Primärseite (131) mit dem gemeinsamen Verbindungsknoten (P) gekoppelt ist, ein erster Anschluss der Sekundärseite (132) mit einem ersten Differenz-Eingangsanschluss der Differenzschaltung (121) gekoppelt ist, und ein zweiter Anschluss der Sekundärseite (132) mit einem zweiten Differenz-Eingangsanschluss der Differenzschaltung (121) gekoppelt ist.

2. Der Verstärker mit variabler Verstärkung (100) nach Anspruch 1, wobei der gemeinsame Verbindungsknoten (P) ein virtueller Masseknoten ist.

3. Der Verstärker mit variabler Verstärkung (100) nach Anspruch 1, wobei der CS-Verstärker (110) der ersten Stufe umfasst:
einen ersten Transistor (M1), wobei ein zweiter Anschluss des ersten Transistors (M1) als der Ausgangsanschluss des CS-Verstärkers (110) der ersten Stufe dient; und
ein Eingangsanpassungsnetzwerk (1101), umfassend eine erste Induktivität (Lg), einen Anpassungskondensator (Cex) und eine zweite Induktivität (Ls), wobei die erste Induktivität (Lg) zwischen einem Eingangsanschluss des CS-Verstärkers (110) der ersten Stufe und einem Steueranschluss des ersten Transistors (M1) gekoppelt ist, der Anpassungskondensator (Cex) zwischen dem Steueranschluss des ersten Transistors (M1) und einem ersten Anschluss des ersten Transistors (M1) gekoppelt ist und die zweite Induktivität (Ls) zwischen dem ersten Anschluss des ersten Transistors (M1) und einem Masseanschluss gekoppelt ist.

4. Der Verstärker mit variabler Verstärkung (100) nach Anspruch 1, wobei die Differenzschaltung (121) umfasst:
einen zweiten Transistor (M2), wobei ein erster Anschluss des zweiten Transistors (M2) mit dem gemeinsamen Verbindungsknoten (P) gekoppelt ist, ein Steueranschluss des zweiten Transistors (M2) als der erste Differenz-Eingangsanschluss der Differenzschaltung (121) dient und ein zweiter Anschluss des zweiten Transistors (M2) als ein erster Ausgangsanschluss der Differenzschaltung (121) dient; und
einen dritten Transistor (M3), wobei ein erster Anschluss des dritten Transistors (M3) mit dem gemeinsamen Verbindungsknoten (P) gekoppelt ist, ein Steueranschluss des dritten Transistors (M3) als der zweite Differenz-Eingangsanschluss der Differenzschaltung (121) dient und ein zweiter Anschluss des dritten Transistors (M3) als ein zweiter Ausgangsanschluss der Differenzschaltung (121) dient.

5. Der Verstärker mit variabler Verstärkung (100) nach Anspruch 4, wobei die Stromlenkungsschaltung (122) umfasst:
einen vierten Transistor (M4), wobei ein erster Anschluss des vierten Transistors (M4) mit dem gemeinsamen Verbindungsknoten (P) gekoppelt ist, ein Steueranschluss des vierten Transistors (M4) mit einer Steuerspannung (Vctrl) gekoppelt ist und ein zweiter Anschluss des vierten Transistors (M4) mit einem zweiten Anschluss des dritten Transistors (M3) gekoppelt ist; und
einen fünften Transistor (M5), wobei ein erster Anschluss des fünften Transistors (M5) mit dem gemeinsamen Verbindungsknoten (P) gekoppelt ist, ein Steueranschluss des fünften Transistors (M5) mit der Steuerspannung (Vctrl) gekoppelt ist und ein zweiter Anschluss des fünften Transistors (M5) mit einem zweiten Anschluss des zweiten Transistors (M2) gekoppelt ist.

6. Der Verstärker mit variabler Verstärkung (100) nach Anspruch 4, wobei die Stromlenkungsschaltung (122) umfasst:
eine vierte Transistorgruppe, umfassend eine Vielzahl von vierten Untertransistoren (M41 bis M44), wobei ein erster Anschluss jedes der vierten Untertransistoren (M41 bis M44) mit dem gemeinsamen Verbindungsknoten (P) gekoppelt ist, ein Steueranschluss jedes der vierten Untertransistoren (M41 bis M44) mit einem digitalen Steuersignal gekoppelt ist und ein zweiter Anschluss jedes der vierten Untertransistoren (M41 bis M44) mit einem zweiten Anschluss des dritten Transistors (M3) gekoppelt ist; und
eine fünfte Transistorgruppe, umfassend eine Vielzahl von fünften Untertransistoren (M51 bis M54), wobei ein erster Anschluss jedes der fünften Untertransistoren (M51 bis M54) mit dem gemeinsamen Verbindungsknoten (P) gekoppelt ist, ein Steueranschluss jedes der fünften Untertransistoren (M51 bis M54) mit dem digitalen Steuersignal gekoppelt ist und ein zweiter Anschluss jedes der fünften Untertransistoren (M51 bis M54) mit einem zweiten Anschluss des zweiten Transistors (M2) gekoppelt ist.

7. Der Verstärker mit variabler Verstärkung (100) nach Anspruch 5, wobei der CS-Verstärker (120) der zweiten Stufe ferner umfasst:
einen ersten Kondensator (C1), wobei ein erster Anschluss des ersten Kondensators (C1) mit dem Steueranschluss des zweiten Transistors (M2) gekoppelt ist, ein zweiter Anschluss des ersten Kondensators (C1) mit dem zweiten Anschluss des dritten Transistors (M3) und dem zweiten Anschluss des vierten Transistors (M4) gekoppelt ist; und
einen zweiten Kondensator (C2), wobei ein erster Anschluss des zweiten Kondensators (C2) mit dem Steueranschluss des dritten Transistors (M3) gekoppelt ist und ein zweiter Anschluss des zweiten Kondensators (C2) mit dem zweiten Anschluss des zweiten Transistors (M2) und dem zweiten Anschluss des fünften Transistors (M5) gekoppelt ist.

8. Der Verstärker mit variabler Verstärkung (100) nach Anspruch 1, ferner umfassend:
einen zweiten Transformator (123), der mit einem ersten Ausgangsanschluss der Differenzschaltung (121) und einem zweiten Ausgangsanschluss der Differenzschaltung (121) gekoppelt ist.

9. Ein Betriebsverfahren eines Verstärkers mit variabler Verstärkung (100), wobei der Verstärker mit variabler Verstärkung (100) einen CS-Verstärker (110) der ersten Stufe, einen CS-Verstärker (120) der zweiten Stufe und einen ersten Transformator (130) umfasst, wobei der erste Transformator (130) zwischen dem CS-Verstärker (110) der ersten Stufe und dem CS-Verstärker (120) der zweiten Stufe gekoppelt ist, und das Betriebsverfahren umfasst:
Konfigurieren einer Differenzschaltung (121) und einer Stromlenkungsschaltung (122) in dem CS-Verstärker (120) der zweiten Stufe, wobei die Differenzschaltung (121) und die Stromlenkungsschaltung (122) mit einem gemeinsamen Verbindungsknoten (P) gekoppelt sind und der gemeinsame Verbindungsknoten (P) ein virtueller Masseknoten ist;
Abziehen zumindest eines Teils eines durch die Differenzschaltung (121) fließenden Stroms von dem gemeinsamen Verbindungsknoten (P) unter Verwendung der Stromlenkungsschaltung (122); und
Ändern einer Verstärkung des Verstärkers mit variabler Verstärkung (100) entsprechend einer durch die Stromlenkungsschaltung (122) abgezogenen Strommenge.

10. Das Betriebsverfahren nach Anspruch 9, wobei das Abziehen zumindest eines Teils des durch die Differenzschaltung (121) fließenden Stroms von dem gemeinsamen Verbindungsknoten (P) unter Verwendung der Stromlenkungsschaltung (122) umfasst:
Steuern eines durch die Stromlenkungsschaltung (122) abgezogenen Stroms unter Verwendung einer Steuerspannung (Vctrl); und
Ändern des durch die Differenzschaltung (121) fließenden Stroms entsprechend dem durch die Stromlenkungsschaltung (122) abgezogenen Strom.

11. Das Betriebsverfahren nach Anspruch 9, ferner umfassend:
Konfigurieren eines ersten Kondensators (C1) und eines zweiten Kondensators (C2) in dem CS-Verstärker (120) der zweiten Stufe, wobei ein erster Anschluss des ersten Kondensators (C1) mit einem ersten Differenz-Eingangsanschluss der Differenzschaltung (121) gekoppelt ist und ein zweiter Anschluss des ersten Kondensators (C1) mit einem zweiten Ausgangsanschluss der Differenzschaltung (121) und einem ersten Ausgangsanschluss der Stromlenkungsschaltung (122) gekoppelt ist, wobei ein erster Anschluss des zweiten Kondensators (C2) mit einem zweiten Differenz-Eingangsanschluss der Differenzschaltung (121) gekoppelt ist und ein zweiter Anschluss des zweiten Kondensators (C2) mit einem ersten Ausgangsanschluss der Differenzschaltung (121) und einem zweiten Ausgangsanschluss der Stromlenkungsschaltung (122) gekoppelt ist; und
Beseitigen von parasitären Kapazitätswerten in der Differenzschaltung (121) und der Stromlenkungsschaltung (122) unter Verwendung des ersten Kondensators (C1) und des zweiten Kondensators (C2).

12. Das Betriebsverfahren nach Anspruch 9, wobei die Stromlenkungsschaltung (122) eine Vielzahl von Untertransistoren (M41 bis M44 und M51 bis M54) umfasst und das Betriebsverfahren ferner umfasst:
Steuern eines Leitfähigkeitszustands jedes der Untertransistoren (M41 bis M44 und M51 bis M54) unter Verwendung eines digitalen Steuersignals (Vctrl), sodass die Stromlenkungsschaltung (122) Ströme mit unterschiedlichen Stromwerten von dem gemeinsamen Verbindungsknoten (P) abzieht; und
Ändern einer Verstärkung des Verstärkers mit variabler Verstärkung (100) entsprechend den durch die Stromlenkungsschaltung (122) abgezogenen Strömen mit den unterschiedlichen Stromwerten.

13. Das Betriebsverfahren nach Anspruch 9, ferner umfassend:
Betreiben des CS-Verstärkers (120) der zweiten Stufe mit einer Betriebsspannung (VDD), wobei die Betriebsspannung (VDD) kleiner oder gleich 1 Volt ist.

## Revendications

1. Un amplificateur (100) à gain variable, comprenant :
un amplificateur (110) à source commune (CS) de premier étage ;
un amplificateur (120) à source commune (CS) de deuxième étage, comprenant un circuit différentiel (121) et un circuit (122) de pilotage de courant, le circuit différentiel (121) et le circuit (122) de pilotage de courant étant raccordés à un nœud de connexion commun (P), et le circuit (122) de pilotage de courant prélevant au moins une partie d'un courant s'écoulant à travers le circuit différentiel (121) à partir du nœud de connexion commun (P) ; et
un premier transformateur (130), comprenant un côté primaire (131) et un côté secondaire (132), une première borne du côté primaire (131) étant raccordée à une borne de sortie de l'amplificateur CS (110) de premier étage, une deuxième borne du côté primaire (131) étant raccordée au nœud de connexion commun (P), une première borne du côté secondaire (132) étant raccordée à une première borne d'entrée différentielle du circuit différentiel (121), et une deuxième borne du côté secondaire (132) étant raccordée à une deuxième borne d'entrée différentielle du circuit différentiel (121).

2. L'amplificateur (100) à gain variable tel que revendiqué dans la revendication 1, dans lequel le nœud de connexion commun (P) est un nœud de masse virtuelle.

3. L'amplificateur (100) à gain variable tel que revendiqué dans la revendication 1, dans lequel l'amplificateur CS (110) de premier étage comprend :
un premier transistor (M1), dont une deuxième borne sert de borne de sortie de l'amplificateur CS (110) de premier étage ; et
un réseau (1101) d'adaptation d'entrée, comprenant une première inductance (Lg), un condensateur d'adaptation (Cex) et une deuxième inductance (Ls), la première inductance (Lg) étant raccordée entre une borne d'entrée de l'amplificateur CS (110) de premier étage et une borne de commande du premier transistor (M1), le condensateur d'adaptation (Cex) étant raccordé entre la borne de commande du premier transistor (M1) et une première borne du premier transistor (M1), et la deuxième inductance (Ls) étant raccordée entre la première borne du premier transistor (M1) et une borne de masse.

4. L'amplificateur (100) à gain variable tel que revendiqué dans la revendication 1, dans lequel le circuit différentiel (121) comprend :
un deuxième transistor (M2), dont une première borne est raccordée au nœud de connexion commun (P), une borne de commande du deuxième transistor (M2) servant de première borne d'entrée différentielle du circuit différentiel (121), et une deuxième borne du deuxième transistor (M2) servant de première borne de sortie du circuit différentiel (121) ; et
un troisième transistor (M3), dont une première borne est raccordée au nœud de connexion commun (P), une borne de commande du troisième transistor (M3) servant de deuxième borne d'entrée différentielle du circuit différentiel (121), et une deuxième borne du troisième transistor (M3) servant de deuxième borne de sortie du circuit différentiel (121).

5. L'amplificateur (100) à gain variable tel que revendiqué dans la revendication 4, dans lequel le circuit (122) de pilotage de courant comprend :
un quatrième transistor (M4), dont une première borne est raccordée au nœud de connexion commun (P), une borne de commande du quatrième transistor (M4) étant raccordée à une tension de commande (Vctrl), et une deuxième borne du quatrième transistor (M4) étant raccordée à une deuxième borne du troisième transistor (M3) ; et
un cinquième transistor (M5), dont une première borne est raccordée au nœud de connexion commun (P), une borne de commande du cinquième transistor (M5) étant reliée à la tension de commande (Vctrl), et une deuxième borne du cinquième transistor (M5) étant raccordée à une deuxième borne du deuxième transistor (M2).

6. L'amplificateur (100) à gain variable tel que revendiqué dans la revendication 4, dans lequel le circuit (122) de pilotage de courant comprend :
un quatrième groupe de transistors, comprenant une pluralité de quatrièmes sous-transistors (M41 à M44), une première borne de chacun des quatrièmes sous-transistors (M41 à M44) étant raccordée au nœud de connexion commun (P), une borne de commande de chacun des quatrièmes sous-transistors (M41 à M44) étant raccordée à un signal de commande numérique, et une deuxième borne de chacun des quatrièmes sous-transistors (M41 à M44) étant raccordée à une deuxième borne du troisième transistor (M3) ; et
un cinquième groupe de transistors comprenant une pluralité de cinquièmes sous-transistors (M51 à M54), une première borne de chacun des cinquièmes sous-transistors (M51 à M54) étant raccordée au nœud de connexion commun (P), une borne de commande de chacun des cinquièmes sous-transistors (M51 à M54) étant reliée au signal de commande numérique, et une deuxième borne de chacun des cinquièmes sous-transistors (M51 à M54) étant raccordée à une deuxième borne du deuxième transistor (M2).

7. L'amplificateur (100) à gain variable tel que revendiqué dans la revendication 5, dans lequel l'amplificateur CS de deuxième étage (120) comprend en outre :
un premier condensateur (C1), dont une première borne est raccordée à la borne de commande du deuxième transistor (M2), et dont une deuxième borne est raccordée à la deuxième borne du troisième transistor (M3) et à la deuxième borne du quatrième transistor (M4) ; et
un deuxième condensateur (C2), dont une première borne est raccordée à la borne de commande du troisième transistor (M3), et dont une deuxième borne est raccordée à la deuxième borne du deuxième transistor (M2) et à la deuxième borne du cinquième transistor (M5).

8. L'amplificateur (100) à gain variable tel que revendiqué dans la revendication 1, comprenant en outre :
un deuxième transformateur (123) raccordé à une première borne de sortie du circuit différentiel (121) et à une deuxième borne de sortie du circuit différentiel (121).

9. Un procédé de fonctionnement d'un amplificateur (100) à gain variable, dans lequel l'amplificateur (100) à gain variable comprend un amplificateur CS (110) de premier étage, un amplificateur CS (120) de deuxième étage et un premier transformateur (130), le premier transformateur (130) étant raccordé entre l'amplificateur CS (110) de premier étage et l'amplificateur CS (120) de deuxième étage, et le procédé de fonctionnement comprend :
le fait de configurer un circuit différentiel (121) et un circuit (122) de pilotage de courant dans l'amplificateur CS (120) de deuxième étage, le circuit différentiel (121) et le circuit (122) de pilotage de courant étant raccordés à un nœud de connexion commun (P), et le nœud de connexion commun (P) étant un nœud de masse virtuelle ;
le fait de prélever au moins une partie d'un courant s'écoulant à travers le circuit différentiel (121) à partir du nœud de connexion commun (P), en utilisant le circuit (122) de pilotage de courant ; et
le fait de modifier un gain de l'amplificateur (100) à gain variable en fonction d'une intensité de courant prélevée par le circuit (122) de pilotage de courant.

10. Le procédé de fonctionnement tel que revendiqué dans la revendication 9, dans lequel le prélèvement d'au moins une partie du courant s'écoulant dans le circuit différentiel (121) à partir du nœud de connexion commun (P) en utilisant le circuit de commutation de courant (122) comprend :
le fait de commander un courant consommé par le circuit (122) de pilotage de courant en utilisant une tension de commande (Vctrl) ; et
le fait de modifier le courant s'écoulant à travers le circuit différentiel (121) en fonction du courant consommé par le circuit (122) de pilotage de courant.

11. Le procédé de fonctionnement tel que revendiqué dans la revendication 9, comprenant en outre :
le fait de configurer un premier condensateur (C1) et un deuxième condensateur (C2) dans l'amplificateur CS de deuxième étage (120), une première borne du premier condensateur (C1) étant raccordée à une première borne d'entrée différentielle du circuit différentiel (121), et une deuxième borne du premier condensateur (C1) étant raccordée à une deuxième borne de sortie du circuit différentiel (121) et à une première borne de sortie du circuit (122) de pilotage de courant, une première borne du deuxième condensateur (C2) étant raccordée à une deuxième borne d'entrée différentielle du circuit différentiel (121), et une deuxième borne du deuxième condensateur (C2) étant raccordée à une première borne de sortie du circuit différentiel (121) et à une deuxième borne de sortie du circuit (122) de pilotage de courant ; et
le fait d'éliminer les valeurs de capacité parasite dans le circuit différentiel (121) et le circuit (122) de pilotage de courant en utilisant le premier condensateur (C1) et le deuxième condensateur (C2).

12. Le procédé de fonctionnement tel que revendiqué dans la revendication 9, dans lequel le circuit (122) de pilotage de courant comprend une pluralité de sous-transistors (M41 à M44 et M51 à M54), et le procédé de fonctionnement comprend en outre :
le fait de commander l'état de conduction de chacun des sous-transistors (M41 à M44 et M51 à M54) au moyen d'un signal de commande numérique (Vctrl), de sorte que le circuit (122) de pilotage de courant prélève des courants de valeurs différentes à partir du nœud de connexion commun (P) ; et
le fait de modifier un gain de l'amplificateur (100) à gain variable en fonction des courants de valeurs différentes prélevés par le circuit (122) de pilotage de courant.

13. Le procédé de fonctionnement tel que revendiqué dans la revendication 9, comprenant en outre :
le fait de faire fonctionner l'amplificateur CS (120) de deuxième étage à une tension de fonctionnement (VDD), la tension de fonctionnement (VDD) étant inférieure ou égale à 1 volt.
